(19) Europäisches Patentamt / European Patent Office / Office européen des brevets

(11) EP 4 746 221 A1

(12) EUROPEAN PATENT APPLICATION

(43) Date of publication:
20.05.2026 Bulletin 2026/21

(21) Application number: 25215830.8

(22) Date of filing: 14.11.2025

(51) International Patent Classification (IPC):
H02H 1/00 (2006.01)          H02H 7/26 (2006.01)
H04J 3/06 (2006.01)          H02H 3/28 (2006.01)

(52) Cooperative Patent Classification (CPC):
H02H 3/28; H02H 1/0061; H02H 7/261;
H04J 3/0667

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 15.11.2024  CN 202411633627

(71) Applicant: SCHNEIDER ELECTRIC INDUSTRIES
SAS
92500 Rueil-Malmaison (FR)

(72) Inventors:
• ZHENG, Kuncheng
  Shanghai 201203 (CN)
• LI, Chao
  Shanghai 201203 (CN)
• LI, Rong
  Shanghai 201203 (CN)

(74) Representative: Lavoix
62, rue de Bonnel
69448 Lyon Cedex 03 (FR)

(54) **METHOD PERFORMED BY A DIFFERENTIAL RELAYING PROTECTION APPARATUS**

(57) The present disclosure provides a method performed by a differential relaying protection apparatus (102), the method includes: obtaining a first plurality of sample data having a first plurality of sample counts (401), wherein the first plurality of sample counts are associated with a first clock in the differential relaying protection apparatus; mapping the first plurality of sample data having the first plurality of sample counts to a second plurality of sample data having a second plurality of sample counts (402), wherein the second plurality of sample counts are associated with a second clock in the differential relaying protection apparatus (102), and the first clock and the second clock run independently; receiving a plurality of sample data having the second plurality of sample counts from one or more other (202) differential relaying protection apparatuses (403); determining a differential current based on the second plurality of sample data and the plurality of sample data (404); and determining whether a circuit fault occurs based on a value of the differential current (405).

FIG. 1

**Description**

TECHNICAL FIELD

The present disclosure relates to a method performed by a differential relaying protection apparatus, and more specifically, the present disclosure relates to a method performed by the differential relaying protection apparatus when the differential relaying protection apparatus comprises two independently running clocks.

BACKGROUND

Differential relaying protection is implemented based on the principle of Kirchhoff current theorem (a sum of currents flowing into a node in a circuit is equal to zero). An electrical device to be protected (e.g., a transformer, a transmission line, etc.) is considered as a node. When the device operates normally, the currents flowing into and out of the electrical device is equal, a differential current is zero, and the differential relaying protection does not operate. When a fault occurs within the device, the currents flowing into and out of the electrical device is no longer equal, the differential current is greater than zero, and when the current is greater than a setting value of the differential relaying protection apparatus, the protection is activated and the faulty device is disconnected from a power supply.

One of technical keys to implementing the differential relaying protection is to realize synchronization among current sampling values at respective ends of the electrical device, such as the transmission lines. In some schemes, it is possible to synchronize the current sampling values by time synchronization of substations based on a Global Positioning System (GPS). However, there are many uncertainties in the GPS-based current sampling values synchronization scheme. For example, GPS signals may become weak for a period of time due to obstructions from buildings, terrain, and other obstructions, as well as weather factors. In this case, a synchronization effect of the GPS-based current sampling value synchronization scheme may deteriorate or fail.

To this end, the present disclosure proposes a method performed by the differential relaying protection apparatus of the electrical device. For different differential relaying protection apparatuses in different electrical devices, two independently running clocks are disposed within each of the differential relaying protection apparatuses, where a first clock may or may not be synchronized with a master clock of the electrical device in which the differential relaying protection apparatus is located, and a second clock is a Precision Time Partnership (PTP) clock and is synchronized with the second clocks in the other differential relaying protection apparatus via the PTP. By mapping electrical quantities sampled by the different differential relaying protection apparatuses driven by respective first clocks in the different devices to electrical quantities based on the second clock, i.e., electrical quantities aligned in time, calculation of differential current is simplified, thereby simplifying a process of determining whether a circuit fault occurs during relay protection.

SUMMARY

According to an aspect of embodiments of the present disclosure, a method performed by a differential relaying protection apparatus is provided, the method comprises: obtaining a first plurality of sample data having a first plurality of sample counts, wherein the first plurality of sample counts are associated with a first clock in the differential relaying protection apparatus; mapping the first plurality of sample data having the first plurality of sample counts to a second plurality of sample data having a second plurality of sample counts, wherein the second plurality of sample counts are associated with a second clock in the differential relaying protection apparatus, and the first clock and the second clock run independently; receiving, from one or more other differential relaying protection apparatuses, a plurality of sample data having the second plurality of sample counts; determining a differential current based on the second plurality of sample data and the plurality of sample data; and determining whether a circuit fault occurs based on a value of the differential current.

In some examples, wherein obtaining a first plurality of sample data having a first plurality of sample counts comprises: sampling, by the differential relaying protection apparatus, based on a first sampling frequency under the first clock to obtain the first plurality of sample data; or receiving, by the differential relaying protection apparatus and from a merging unit, the first plurality of sample data sampled by the merging unit at the first sampling frequency under the first clock, wherein the first sampling frequency is a predetermined sampling frequency.

In some examples, the sample data is an electrical quantity.

In some examples, mapping the first plurality of sample data having the first plurality of sample counts to a second plurality of sample data having a second plurality of sample counts comprises: determining a ratio and a time difference between the second clock and the first clock; determining the second plurality of sample counts based on the first plurality of sample counts; and determining the second plurality of sample data having the second plurality of sample counts based on the ratio, the time difference, the first plurality of sample counts, the first plurality of sample data and the second plurality of sample counts.

In some examples, determining a ratio and a time difference between the second clock and the first clock comprises, for each second the first clock elapses: determining a ratio between a length of time elapsed by the second clock and a length of time elapsed by the first clock as the ratio between the first clock and the second clock for the second; and determining a difference between a current time of the second clock and a current time of the first clock as the time difference between the first clock and the second clock for the second.

In some examples, determining the second plurality of sample counts based on the first plurality of sample counts comprises: determining a maximum sample count and a minimum sample count among the first plurality of sample counts; for each of the maximum sample count and the minimum sample count, determining a specific maximum sample count and a specific minimum sample count corresponding to the maximum sample count and the minimum sample count, respectively, based on the ratio, the time difference, the first sampling frequency and a second sampling frequency; and determining integers between the specific maximum sample count and the specific minimum sample count as the second plurality of sample counts, wherein the second sampling frequency is a predetermined sampling frequency.

In some examples, determining the second plurality of sample data having the second plurality of sample counts based on the ratio, the time difference, the first plurality of sample counts, the first plurality of sample data and the second plurality of sample counts comprises, for each sample count of the second plurality of sample counts: determining a specific sample count corresponding to the sample count based on the ratio, the time difference, the first sampling frequency and the second sampling frequency; determining a specific sample data having the specific sample count based on the first plurality of sample counts, the first plurality of sample data and the specific sample count; and determining the specific sample data as a sample data having the sample count.

In some examples, determining a specific sample data having the specific sample count based on the first plurality of sample counts, the first plurality of sample data and the specific sample count comprises: determining, among the first plurality of sample counts, a sample count being numerically closest to the specific sample count; and determining a sample data having the sample count as the specific sample data.

In some examples, determining a specific sample data having the specific sample count based on the first plurality of sample counts, the first plurality of sample data and the specific sample count comprises: determining, among the first plurality of sample counts, two sample counts that are numerically adjacent to the specific sample count; and interpolating, based on two sample data having the two sample counts, to determine the specific sample data.

In some examples, the second clock is a Precision Time Protocol (PTP) clock.

In some examples, determining whether a circuit failure occurs based on a value of the differential current comprises: determining that the circuit failure occurs when the value of the differential current is greater than a threshold.

In some examples, the method further comprises: storing the second plurality of sample data having the second plurality of sample counts; and transmitting the second plurality of sample data having the second plurality of sample counts to the one or more other differential relaying protection apparatuses.

According to another aspect of an embodiment of the present disclosure, a differential relaying protection apparatus is provided, the apparatus comprises: a clock module configured to create a first clock and a second clock, wherein the first clock and the second clock run independently; a transceiver module; and a processing module configured to perform the aforementioned methods.

According to further another aspect of embodiments of the present disclosure, a differential relaying protection apparatus is provided, the apparatus comprises: a first clock module configured to create a first clock; a second clock module configured to create a second clock, wherein the first clock and the second clock run independently; a transceiver module; and a processing module configured to perform the aforementioned methods.

According to still another aspect of embodiments of the present disclosure, a power device is provided, the power device comprises: a differential relaying protection apparatus configured to perform the aforementioned methods.

According to further another aspect of embodiments of the present disclosure, a computer-readable storage medium having computer-executable instructions stored thereon is provided, when executed by a processor, the instructions being used to implement the aforementioned methods.

Other aspects, advantages, and salient features of the present disclosure will become clear to those skilled in the art from the following detailed description in conjunction with the accompanying drawings which disclose various embodiments of the present disclosure.

BRIEF DESCRIPTION OF THE DRAWINGS

The present invention will be more readily understood by the following detailed description with the aid of the accompanying drawings, wherein the same symbols designate units of the same construction and in which:

FIG. 1 illustrates a schematic diagram of a substation including a differential relaying protection apparatus according to an embodiment of the present disclosure;
FIG. 2 illustrates a graph depicting a ratio between a second clock and a first clock, according to an embodiment of the present disclosure;

FIG. 3 illustrates a schematic diagram of a first plurality of sample data having a first plurality of sample counts and a second plurality of sample data having a second plurality of sample counts, according to an embodiment of the present disclosure;

FIG. 4 illustrates a flowchart of a method performed by a differential relaying protection apparatus according to an embodiment of the present disclosure;

FIG. 5A illustrates a schematic diagram of a differential relaying protection apparatus according to an embodiment of the present disclosure;

FIG. 5B illustrates a schematic diagram of another differential relaying protection apparatus e according to an embodiment of the present disclosure; and

FIG. 6 illustrates a schematic diagram of a non-transitory computer readable medium according to an embodiment of the present disclosure.

Throughout the accompanying drawings, similar reference numerals will be understood to refer to similar parts, components, and structures.

DETAILED DESCRIPTION

The technical solutions in the embodiments of the present invention will be described clearly and completely in the following in conjunction with the accompanying drawings in the embodiments of the present invention, and it is obvious that the described embodiments are a part of the embodiments of the present invention instead of all of the embodiments. Based on the embodiments in the present invention, all other embodiments obtained by a person of ordinary skill in the art without making creative labor fall within the scope of protection of the present invention.

In addition, one of ordinary skill in the art will understand that the elements in the accompanying drawings are illustrated for simplicity and may not necessarily be drawn to scale. For example, the dimensions of some elements in the accompanying drawings may be enlarged relative to other elements to help improve understanding of aspects of the embodiments. In addition, one or more elements may have been represented by various symbols in the accompanying drawings, and the accompanying drawings may show only those particular details that are relevant to an understanding of the embodiments of the present disclosure so that the accompanying drawings do not have to be obscured by details that would be obvious to a person of ordinary skill in the art who would benefit from the descriptions herein.

In addition, it should be noted that in this specification, A connected to B may mean "A is directly connected to B" or "A is connected to B via other intermediate". A connected between B and C may mean "A is directly connected to B and C" or "A is connected to B and C via other middleware". In addition, it should be noted that in this specification, "first" and "second" are used only to distinguish one element from another element, and are not used to rank or limit the importance or priority of different elements.

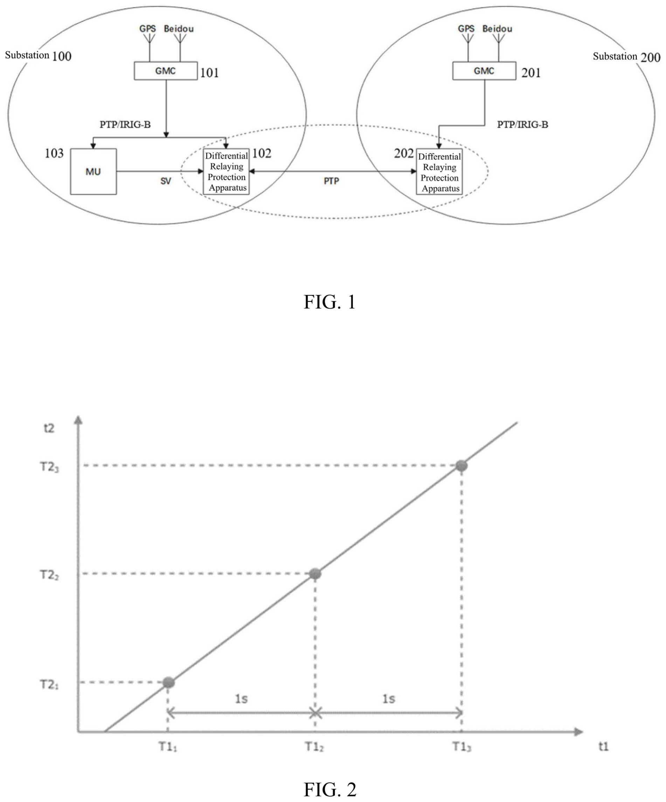

FIG. 1 illustrates a schematic diagram of a substation including a differential relaying protection apparatus according to an embodiment of the present disclosure.

As shown in FIG. 1, a substation 100 includes a clock unit 101, a differential relaying protection apparatus 102, and a merging unit (MU) 103, and a substation 200 includes a clock unit 201 and a differential relaying protection apparatus 202. It should be appreciated that the substations shown in FIG. 1 are only examples, and that a substation system may include more or less substations than those shown in FIG. 1, and that the substations may include more or less units than those shown in FIG. 1. Following descriptions are made by taking the substation 101 as an example.

In some embodiments, each unit in the substation 100 may achieve time synchronization through a form of master-slave clocks. For example, the clock unit 101 of the substation 100 operates as a master clock (GMC), and the differential relaying protection apparatus 102 and the merger unit 103 each comprises a clock unit operating as a slave clock of the clock unit 101. Time synchronization between the master clock and the slave clocks may be achieved via a Precision Time Protocol (PTP) or IRIG-B (inter-range instrumentation group-B) code. In some embodiments, the master clock may obtain a standard time signal from a Global Positioning System (GPS) satellite or a standard time signal from a BeiDou Navigation Satellite System.

According embodiments of the present disclosure, the differential relaying protection apparatus 102 may have two independently running (e.g., unsynchronized) clocks, one clock may be synchronized with the clock unit 101 of the substation 100 to operate as a slave clock of the clock unit 101, or may be operated independently without being synchronized with the clock unit 101 of the substation 100, and the other clock is synchronized with corresponding clock(s) in the other differential relaying protection apparatuses. Hereinafter, the former will be referred to as a first clock, and the latter will be referred to as a second clock. It will be appreciated by those skilled in the art that, according to embodiments of the present disclosure, each differential relaying protection apparatus includes a first clock and a second clock. In some embodiments, the synchronization between the second clocks in the different differential relaying protection apparatuses may be achieved via PTP. Referring to FIG. 1, the synchronization between the second clock of the differential relaying protection apparatus 102 of the substation 100 and the second clock of the differential relaying protection apparatus 202 of the substation 200 may be achieved via PTP. In some embodiments, the substation 100 may include multiple differential relaying protection apparatuses, and the second clocks of the multiple differential relaying protection apparatuses may also be synchronized via PTP.

In addition, the differential relaying protection apparatus 102 may be driven by the first clock to sample electrical quantities in the substation 100 at a first sampling frequency $fs_1$ based on an IEC 61850-9-2 protocol, so as to obtain a sampling result SV. The sampling result SV may include sample counts and sample data, wherein the sample count corresponds to the sample data one-to-one. The first sampling frequency $fs_1$ is a predetermined sampling frequency, and in some embodiments, the first sampling frequency $fs_1$ may be 4000 Hz. However, the present disclosure is not limited thereto, and those skilled in the art may apply different sampling frequencies as needed. In some embodiments, the differential relaying protection apparatus 102 may receive the sample result SV from the merging unit 103. Hereinafter, the sample counts included in the sample result SV are referred to as a first plurality of sample counts, and the sample data included in the sample result SV is referred to as a first plurality of sample data.

In some embodiments, the differential relaying protection apparatus 102 may map the first plurality of sample data having the first plurality of sample counts to a second plurality of sample data having a second plurality of sample counts, the second plurality of sample counts are associated with the second clock. The process of mapping the first plurality of sample data having the first plurality of sample counts to the second plurality of sample data having the second plurality of sample counts will be described in detail in connection with FIG. 2 to FIG. 4.

In addition, the differential relaying protection apparatus 102 may further receive a plurality of sample data having the second plurality of sample counts from one or more other differential relaying protection apparatuses. For example, the differential relaying protection apparatus 102 of the substation 100 may receive a third plurality of sample data having the second plurality of sample counts from the differential relaying protection apparatus 202 of the substation 200. As another example, when the substation 100 includes multiple differential relaying protection apparatuses, the differential relaying protection apparatus 102 may further receive a plurality of sample data having the second plurality of sample counts from the other differential relaying protection apparatuses in the substation 100. The differential relaying protection apparatus 102 may determine a differential current based on the second plurality of sample data and the plurality of sample data received from the one or more of the other differential relaying protection apparatuses and determine whether a circuit fault occurs based on a value of the differential current.

As mentioned above, the first clock of the differential relaying protection apparatus 102 of the substation 100 and the first clock of the differential relaying protection apparatus 202 of the substation 200 are usually unsynchronized, and thus, the first plurality of sample data having the first plurality of sample counts sampled by the differential relaying protection apparatus 102 in the substation 100 under its first clock and a fourth plurality of sample data having a third plurality of sample counts sampled by the differential relaying protection apparatus 202 in the substation 200 under its first clock are unaligned in time, such that calculation of the differential current becomes difficult. To this end, the differential relaying protection apparatus 102 in the substation 100 may map the first plurality of sample data having the first plurality of sample counts to the second plurality of sample data having the second plurality of sample counts, and transmit the same to the differential relaying protection apparatus 202 in the substation 200, and similarly the differential relaying protection apparatus 202 in the substation 200 may also map the fourth plurality of sample data having the third plurality of sample counts to the third plurality of sample data having the second plurality of sample counts and transmit the same to the differential relaying protection apparatus 102 in the substation 100. In this way, the second plurality of sample data and the third plurality of sample data are aligned in time, thereby the calculation of the differential current is simplified.

Similarly, when the substation 100 comprises multiple differential relaying protection apparatuses, the first clocks of the multiple differential relaying protection apparatuses are usually unsynchronized, and thus the electrical quantities sampled by the multiple differential relaying protection apparatuses at their respective first clocks are different sample data having different sample counts. As described above, the sample data having the different sample counts may be mapped to the sample data having the same sample counts to simplify the calculation of the differential current.

The merging unit 103 is a physical unit for time- correlated combination of current and voltage data from a secondary converter. In FIG. 1, the combining unit 103 is shown as an individual unit, but in some embodiments, it may be a component of a transformer. In some embodiments, the merging unit 103 may sample the electrical quantities (e.g., voltages and/or currents) in the substation 100 at a first sampling frequency $fs_1$ based on the IEC 61850-9-2 protocol and transmit the results of the sampling to the differential relaying protection apparatus 102 via the SV.

FIG. 2 illustrates a graph depicting a ratio between the second clock and the first clock according to an embodiment of the present disclosure.

Considering that the first clock and the second clock may have different frequencies, periods, phases, or duty cycles due to differences in structure, temperature, and the like, that is, when the first clock elapses 1 second, the second clock may elapse more than 1 second or less than 1 second. Therefore, in order to map the first plurality of sample data having the first plurality of sample counts to the second plurality of sample data having the second plurality of sample counts, a ratio between the second clock and the first clock needs to be calculated.

As shown in FIG. 2, the horizontal axis represents time t1 the first clock elapses, and the vertical axis represents time t2 the second clock elapses. Three points $T1_1$, $T1_2$ and $T1_3$ illustrated on the horizontal axis represents three moments in the time the first clock elapses, where a time interval between $T1_1$ and $T1_2$ is 1 second, and a time interval between $T1_2$ and $T1_3$ is 1 second. Similarly, three points $T2_1$, $T2_2$, and $T2_3$ illustrated on the vertical axis represents three moments in time the second clock elapses. As described above, since the first clock and the second clock run independently, a length of time between the $T2_1$ and $T2_2$ and a length of time between the $T2_2$ and $T2_3$ may be more than 1 second or less than 1 second. In this case, the ratio between the second clock and the first clock may be calculated second-by-second. For example, for 1s between the $T1_1$ and $T1_2$, the ratio $r_{21}$ between the second clock and the first clock may be calculated by the following formula:

$$r_{21} = \frac{T2_2 - T2_1}{T1_2 - T1_1}$$

For another example, for 1s between $T1_2$ and $T1_3$, the ratio $r_{32}$ between the second clock and the first clock may be calculated by the following formula:

$$r_{32} = \frac{T2_3 - T2_2}{T1_3 - T1_2}$$

In some embodiments, a current time of the second clock may be recorded whenever the first clock indicates a whole second, thereby the ratio between the second clock and the first clock is calculated based on the recorded time of the second clock. In some embodiments, a time difference between the second clock and the first clock may further be calculated. For example, for the time $T1_2$ of the first clock, the time difference between the second clock and the first clock may be calculated as $T2_2$ - $T1_2$. In addition, the calculated ratio and time difference between the second clock and the first clock may also be stored for a computational process of mapping the first plurality of sample data having the first plurality of sample counts to the second plurality of sample data having the second plurality of sample counts.

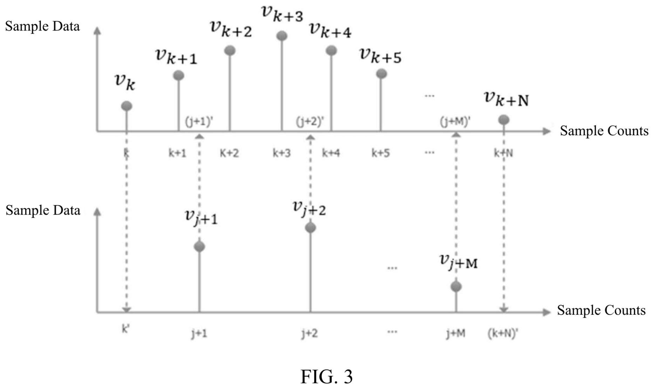

FIG. 3 illustrates a schematic diagram of the first plurality of sample data having the first plurality of sample counts and the second plurality of sample data having the second plurality of sample counts according to an embodiment of the present disclosure.

Taking an example where sampling at a first sampling frequency $fs_1$ in a time interval between the $T1_1$ and $T1_2$, the upper portion of FIG. 3 illustrates the first plurality of sample data having the first plurality of sample counts, where the horizontal axis represents the sample counts, and the vertical axis represents the sample data. The first plurality of sample counts $k$, $k + 1$ ... $k + N$ are illustrated on the horizontal axis, and the first plurality of sample data having the first plurality of sample counts $k$, $k + 1$ ... $k + N$ are $v_k$, $v_{k+1}$ ... $v_{k+N}$ respectively, where $k$ and $N$ each is positive integer. The number of the first plurality of sample counts is related to the first sampling frequency $fs_1$, and the first sampling frequency $fs_1$ may be preset. For example, when the first sampling frequency $fs_1$ is 4000 Hz, the number of the first plurality of sample counts may be 4000.

The lower portion of FIG. 3 illustrates the second plurality of sample data $v_j$, $v_{j+1}$ ... $v_{j+M}$ having the second plurality of sample counts $j$, $j + 1$ ... $j + M$ obtained by mapping the first plurality of sample data $v_k$, $v_{k+1}$ ... $v_{k+N}$ having the first plurality of sample counts $k$, $k + 1$ ... $k + N$. The number of the second plurality of sample counts is related to a second sampling frequency $fs_2$, and the second sampling frequency $fs_2$ may be preset.

In some embodiments, the second plurality of sample counts $j$, $j + 1$ ... $j + M$ may be determined based on the first plurality of sample counts $k$, $k + 1$ ... $k + N$, the ratio $r_{21}$ between the second clock and the first clock, the time difference $T2_2$ - $T1_2$ between the second clock and the first clock, the first sample frequency $fs_1$, and the second sample frequency $fs_2$. A minimum sample count $k$ and a maximum sample count $k + N$ among the first plurality of sample counts are determined firstly. A specific minimum sample count $k'$ and a specific maximum sample count $(k + N)'$ may be calculated based on the minimum sample count $k$ and the maximum sample count $k + N$ using the following formulas, where:

$$k' = \left\{ \frac{k}{fs_1} * r_{21} + (T2_2 - T1_2) \right\} * fs_2$$

$$(k + N)' = \left\{ \frac{k+N}{fs_1} * r_{21} + (T2_2 - T1_2) \right\} * fs_2$$

where $\{\cdot\}$ is a decimalization operator. Multiple positive integers $j, j+1...j+M$ between the $k'$ and $(k+N)'$ may be determined as the second plurality of sample counts. Usually, the number of the second plurality of sample counts is less than that of the first plurality of sample counts.

In some embodiments, the second plurality of sample data $v_j, v_{j+1}... v_{j+M}$ having the second plurality of sample counts $j, j+1... j+M$ may be determined based on the first plurality of sample counts $k, k+1... k+N$, the first plurality of sample data $v_k, v_{k+1}... v_{k+N}$, the ratio $r_{21}$ between the second clock and the first clock, the time difference $T2_2 - T1_2$ between the second clock and the first clock, the first sample frequency $fs_1$, and the second sample frequency $fs_2$.

A process for determining the second plurality of sample data is then described by taking the sample data $v_{j+1}$ having the sample count $j+1$ as an example.

For the sample count $j+1$, a specific sample count $(j+1)'$ corresponding to the sample count $j+1$ is determined based on the ratio $r_{21}$ between the second clock and the first clock, the time difference $T2_2 - T1_2$ between the second clock and the first clock, the first sampling frequency $fs_1$, and the second sampling frequency $fs_2$, where:

$$(j+1)' = \{\frac{\frac{j+1}{fs_2} - (T2_2 - T1_2)}{r_{21}}\} * fs_1$$

where $\{\cdot\}$ is the decimalization operator. For the specific sample count $(j+1)'$, a specific sample data $v_{(j+1)'}$ having the specific sample count $(j+1)'$ is determined. The specific sample data $v_{(j+1)'}$ may be determined based on the specific sample count $(j+1)'$, the first plurality of sample counts $k, k+1... k+N$, the first plurality of sample data $v_k, v_{k+1}... v_{k+N}$.

In some embodiments, a sample count numerically closest to the specific sample count $(j+1)'$ may be determined among the first plurality of sample counts $k, k+1... k+N$, for example, may be $k+1$. In this case, the sample data $v_{k+1}$ having the sample count $k+1$ may be determined as the specific sample data $v_{(j+1)'}$ having the specific sample count $(j+1)'$.

In other embodiments, two sample counts numerically adjacent to the specific sample count$(j+1)'$ may be determined among the first plurality of sample counts $k, k+1... k+N$, for example, may be $k+1$ and $k+2$. In this case, the specific sample data $v_{(j+1)'}$ having the specific sample count $(j+1)'$ may be determined by linear interpolation between the sample data $v_{k+1}$ having the sample count $k+1$ and the sample data $v_{k+2}$ having the sample count $k+2$.

Subsequently, the specific sample data $v_{(j+1)'}$ is determined as the sample data $v_{j+1}$ having the sample count $j+1$. Each of the second plurality of sample data $v_j, v_{j+1}... v_{j+M}$ having the second plurality of sample counts $j, j+1... j+M$ may be determined in the similar manner.

Through the above manner, the first plurality of sample data $v_k, v_{k+1}... v_{k+N}$ having the first plurality of sample counts $k, k+1... k+N$ obtained by sampling at the first sampling frequency $fs_1$ under the first clock may be mapped to the second plurality of sample data $v_j, v_{j+1}... v_{j+M}$ having the second plurality of sample counts $j, j+1... j+M$, where the second plurality of sample counts are associated with the second clock that runs independently from the first clock.

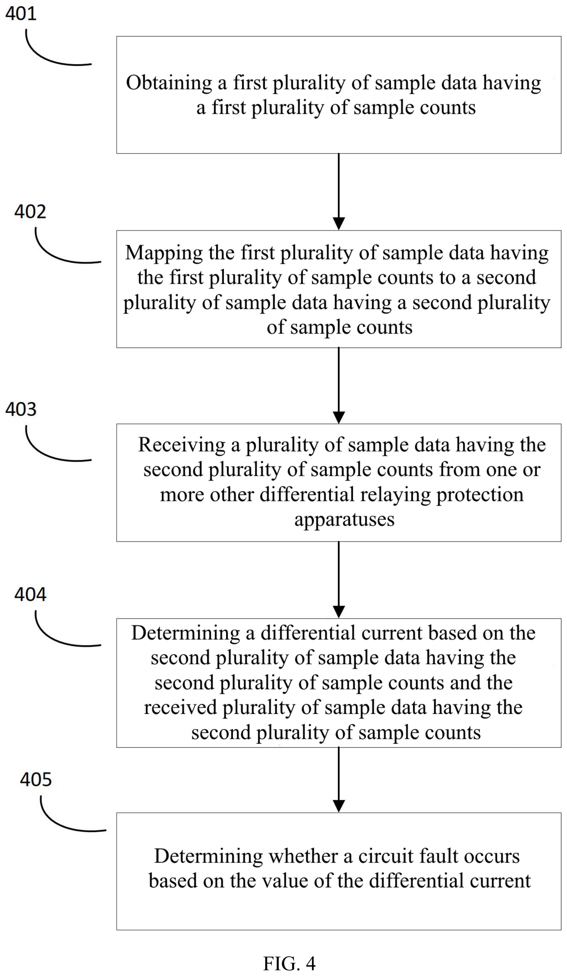

FIG. 4 illustrates a flowchart of a method performed by the differential relaying protection apparatus according to an embodiment of the present disclosure.

At step 401, the differential relaying protection apparatus may obtain the first plurality of sample data having the first plurality of sample counts. As described above, the differential relaying protection apparatus may have the first clock and the second clock, and the first clock and the second clock run independently. The differential relaying protection apparatus may be driven by the first clock to sample the electrical quantities within the substation at the first sampling frequency $fs_1$, so as to obtain the first plurality of sample data having the first plurality of sample counts. The sampling may be based on the IEC 61850-9-2 protocol. In some embodiments, the differential relaying protection apparatus may receive the first plurality of sample data having the first plurality of sample counts from the merging unit.

At step 402, the differential relaying protection apparatus may map the first plurality of sample data having the first plurality of sample counts to the second plurality of sample data having the second plurality of sample counts. As described above, the first clock of the differential relaying protection apparatus may be synchronized with a master clock of a substation including the differential relaying protection apparatus or runs independently, and the second clock may be synchronized with the second clock in another differential relaying protection apparatus. For each differential relaying protection apparatus, mapping the first plurality of sample data having the first plurality of sample counts based on the first clock to the second plurality of sample data having the second plurality of sample counts based on the second clock may cause each differential relaying protection apparatus to obtain the sample data having the same sample counts, i.e., sample data aligned in time, which can simplify the calculation of the differential current. In some embodiments, the calculation of the differential current may be simplified to a vector sum of the sample data from different differential relaying protection apparatuses. How to map the first plurality of sample data having the first plurality of sample counts to the second plurality of sample data having the second plurality of sample counts has been described in detail above with reference to FIG. 2 to FIG. 3, and will not be repeated herein to avoid redundancy.

At step 403, the differential relaying protection apparatus may receive a plurality of sample data having the second plurality of sample counts from one or more other differential relaying protection apparatuses (e.g., differential relaying protection apparatuses in another substation or other differential relaying protection apparatuses in the same substation). As described in step 402, according to the embodiments of the present disclosure, each differential relaying protection apparatus may map the sample data having the respective plurality of sample counts, obtained by sampling at the respective first clocks or received from the merging unit, to the sample data having unified sample counts. For example, referring back to FIG. 1, the differential relaying protection apparatus 102 may map the first plurality of sample data having the first plurality of sample counts to the second plurality of sample data having the second plurality of sample counts, and the differential relaying protection apparatus 202 may map the fourth plurality of sample data having the third plurality of sample counts to the third plurality of sample data having the second plurality of sample counts. The differential relaying protection apparatus 102 may receive the third plurality of sample data having the second plurality of sample counts from the differential relaying protection apparatus 202, and similarly, the differential relaying protection apparatus 202 may receive the second plurality of sample data having the second plurality of sample counts from the differential relaying protection apparatus 102.

At step 404, the differential relaying protection apparatus may determine the differential current based on the second plurality of sample data having the second plurality of sample counts and the plurality of sample data having the second plurality of sample counts received from one or more other differential relaying protection apparatuses. For example, referring back to FIG. 1, when the differential relaying protection apparatus 102 receives the third plurality of sample data having the second plurality of sample counts from the differential relaying protection apparatus 202, since both the second plurality of sample data and the third plurality of sample data have the second plurality of sample counts, i.e., the second plurality of sample data and the third plurality of sample data are aligned in time, the differential relaying protection apparatus 102 may determine the differential current based on the second plurality of sample data having the second plurality of sample counts and the third plurality of sample data having the second plurality of sample counts. In some embodiments, the differential current may be determined by calculating a vector sum of the second plurality of sample data having the second plurality of sample counts and the third plurality of sample data having the second plurality of sample counts. Similarly, when the differential relaying protection apparatus 202 also receives the second plurality of sample data having the second plurality of sample counts from the differential relaying protection apparatus 102, the differential current may also be determined based on the second plurality of sample data having the second plurality of sample counts and the third plurality of sample data having the second plurality of sample counts. It should be understood that while the present disclosure illustrates a system of two substations including differential relaying protection apparatuses, the methods described in the present disclosure may be applicable to a system including more substations. Additionally, although the present disclosure illustrates a case where the differential relaying protection apparatuses locate in different substations, the methods described in the present disclosure may be applicable to situations where multiple differential relaying protection apparatuses locate in the same substation. Further, although the present disclosure is described by taking the substation including the differential relaying protection apparatus as an example, the methods described in the present disclosure may be applicable to any electrical device and/or system including the differential relaying protection apparatuses.

At step 405, the differential relaying protection apparatus may determine whether the circuit fault occurs based on the value of the differential current. For example, when the value of the differential current is greater than a threshold, the differential relaying protection apparatus may determine that the circuit fault occurs. When the differential relaying protection apparatus determines that the circuit fault occurs, it may take timely action to isolate the fault. In some embodiments, the threshold may be predetermined.

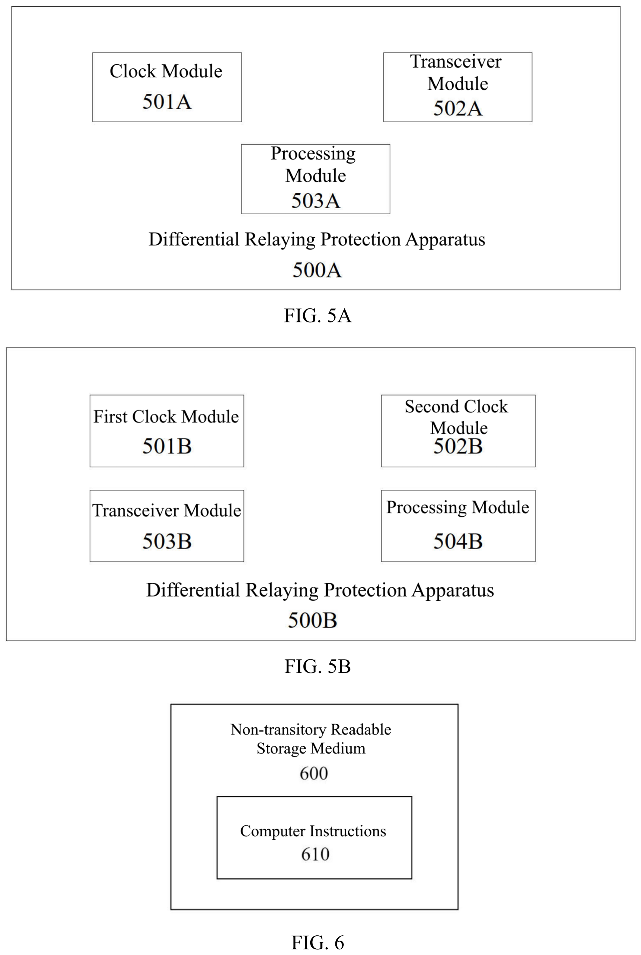

FIG. 5A illustrates a schematic diagram of the differential relaying protection apparatus according to an embodiment of the present disclosure.

As shown in FIG. 5A, a differential relaying protection apparatus 500A may include a clock module 501A, a transceiver module 502A, and a processing module 503A. The clock module 501A may configure a first clock and a second clock for the differential relaying protection apparatus 500A, where the first clock and the second clock run independently. The first clock may be a slave clock of a master clock of a substation where the differential relaying protection apparatus is located and may be time-synchronized with the master clock, or it may be a free clock controlled by a crystal oscillator in the differential relaying protection apparatus itself. In some embodiments, the first clock may be time-synchronized with the master clock via the PTP protocol or the IRIG-B code. The second clock may be time-synchronized with the second clocks in the other differential relaying protection apparatuses. In some embodiments, the second clock may be time-synchronized with the second clocks in the other differential relaying protection apparatuses via the PTP protocol. The transceiver module 502A may receive, from the merging unit, sampling results of the electrical quantities (voltages and/or currents) in the substation and the electrical quantities in the other differential relaying protection apparatuses, and may transmit the second plurality of sample data having the second plurality of sample counts, obtained by mapping, to the other differential relaying protection apparatuses. The processing module 503A may perform the methods of relay protection described with reference to FIG. 1 to FIG. 4.

In some embodiments, the differential relaying protection apparatus 500A may further include a sampling module for sampling the electrical quantities in the substation. In some embodiments, the differential relaying protection apparatus 500A may further include a storage module for storing the second plurality of sample data having the second plurality of sample counts obtained by mapping.

FIG. 5B illustrates a schematic diagram of another differential relaying protection apparatus according to an embodiment of the present disclosure.

As shown in FIG. 5B, a differential relaying protection apparatus 500B may include a first clock module 501B, a second clock module 502B, a transceiver module 503B, and a processing module 504B. The first clock module 501B may configure a first clock for the differential relaying protection apparatus 500B, and the second clock module 502B may configure a second clock for the differential relaying protection apparatus 500B. The first clock and the second clock run independently, i.e., the first clock and the second clock are not time-synchronized. The first clock may be a slave clock of the master clock of the substation where the differential relaying protection apparatus is located and may be time-synchronized with the master clock, or it may be a free clock controlled by a crystal oscillator in the differential relaying protection apparatus itself. In some embodiments, the first clock may be time-synchronized with the master clock via the PTP protocol or the IRIG-B code. The second clock may be time-synchronized with the second clocks in the other differential relaying protection apparatuses. In some embodiments, the second clock may be time-synchronized with the second clocks in the other differential relaying protection apparatuses via the PTP protocol. The transceiver module 503B may receive the sampling results of the electrical quantities (voltages and/or currents) in this substation and the electrical quantities in the other differential relaying protection apparatuses from the merging unit, and may transmit the second plurality of sample data having the second plurality of sample counts, obtained by mapping, to the other differential relaying protection apparatuses. The processing module 504B may perform the method of relay protection described with reference to FIG. 1 to FOG. 4.

Similar to the differential relaying protection apparatus 500A, the differential relaying protection apparatus 500B may further includes a sampling module for sampling electrical quantities in the substation, and a storage module for storing the second plurality of sample data having the second plurality of sample counts obtained by mapping.

FIG. 6 illustrates a schematic diagram of a non-transitory computer readable medium in accordance with embodiments of the present disclosure.

As shown in FIG. 6, the non-transitory readable storage medium 600 has computer instructions 610 stored thereon, when executed by a processor, the processor may perform one or more of the steps in the method and additional aspects of the method performed by the differential relaying protection apparatus as described above.

Exemplarily, the non-transitory readable storage medium 600 may be any combination of one or more computer-readable storage mediums, such as a computer-readable storage medium comprising program code for performing the various methods described above.

Exemplarily, when the program code is read by a computer, the computer may execute the program code stored in the computer storage medium, and perform one or more steps to implement, for example, the various methods described above and additional aspects thereof according to at least one embodiment of the present disclosure.

One of ordinary skill in the art may realize that the units and algorithmic steps of the embodiments described in connection with the embodiments disclosed in the present invention are capable of being realized in the electronic hardware, the computer software, or a combination of both, and that the composition and steps of the embodiments have been described in the foregoing description in general terms according to the functions, in order to clearly illustrate the interchangeability of hardware and software. Whether these functions are performed in hardware or software depends on the specific application and design constraints of the technical solution. The skilled person may use different methods for each specific application to implement the described functions, but such implementation should not be considered beyond the scope of the present invention.

It is clear to those skilled in the field to which it belongs that, for the convenience and brevity of the description, the specific working processes of the above-described systems, apparatuses and units may be referred to the corresponding processes in the foregoing embodiments of the methods, which will not be repeated herein.

In the several embodiments provided in the present invention, it should be understood that the disclosed systems, apparatuses and methods, may be realized in other ways. For example, the above-described embodiments of the device are merely example, e.g., the division of the units described, is merely a logical functional division, and the actual implementation may be divided in other ways, e.g., a plurality of units or components may be combined or may be integrated into another system, or some of the features may be ignored, or not implemented. Another point is that the mutual coupling or direct coupling or communication connection shown or discussed may be an indirect coupling or communication connection through some interface, device or unit, which may be electrical, mechanical or otherwise.

The units illustrated as separated components may or may not be physically separated, and components displayed as units may or may not be physical units, and may either be located in one place or may be distributed over a plurality of network units. Some or all of these units may be selected to fulfill the purpose of this embodiment scheme according to actual needs.

Furthermore, the functional units in the various embodiments of the present invention may be integrated in a single processing unit, or each unit may be physically present separately, or two or more units may be integrated in a single unit. The integrated unit may be realized either in the form of hardware or in the form of a software functional unit.

The integrated units may be stored in a computer-readable storage medium if realized in the form of a software functional unit and sold or used as a separate product. Based on this understanding, the technical solution of the present invention, in essence or as a contribution to the prior art, or all or part of the technical solution, may be embodied in the form of a software product, which is stored in a storage medium comprising a number of instructions to enable a computer device (which may be a personal computer, a server, or a network device, etc.) to carry out all or part of the steps of the method described in various embodiments of the invention, and the computer software product is stored in a storage medium comprising instructions to cause a computer device (which may be a personal computer, a server, a network device, etc.) to perform all or part of the steps of the method described in the various embodiments of the invention. The aforementioned storage medium includes a USB flash drive, a removable hard disk, a read-only memory (ROM, Read-Only Memory), a random access memory (RAM, Random Access Memory), a diskette or a CD-ROM, and other media that may store program code.

The foregoing are only specific embodiments of the present invention, but the scope of protection of the present invention is not limited thereto, and any person skilled in the art who is familiar with the technical field can easily think of changes or substitutions within the scope of the technology disclosed by the present invention, which should be covered by the scope of protection of the present invention. Therefore, the scope of protection of the present invention shall be stated to be subject to the scope of protection of the claims.

**Claims**

1.  A method performed by a differential relaying protection apparatus, comprising:

    obtaining a first plurality of sample data having a first plurality of sample counts, wherein the first plurality of sample counts are associated with a first clock in the differential relaying protection apparatus;
    mapping the first plurality of sample data having the first plurality of sample counts to a second plurality of sample data having a second plurality of sample counts, wherein the second plurality of sample counts are associated with a second clock in the differential relaying protection apparatus, and the first clock and the second clock run independently;
    receiving, from one or more other differential relaying protection apparatuses, a plurality of sample data having the second plurality of sample counts;
    determining a differential current based on the second plurality of sample data and the plurality of sample data; and
    determining whether a circuit fault occurs based on a value of the differential current.

2.  The method of claim 1, wherein obtaining a first plurality of sample data having a first plurality of sample counts comprises:

    sampling, by the differential relaying protection apparatus, based on a first sampling frequency under the first clock to obtain the first plurality of sample data; or
    receiving, by the differential relaying protection apparatus and from a merging unit, the first plurality of sample data sampled by the merging unit at the first sampling frequency under the first clock,
    wherein the first sampling frequency is a predetermined sampling frequency.

3.  The method of claim 1, wherein the sample data is an electrical quantity.

4.  The method of claim 1, wherein mapping the first plurality of sample data having the first plurality of sample counts to a second plurality of sample data having a second plurality of sample counts comprises:

    determining a ratio and a time difference between the second clock and the first clock;
    determining the second plurality of sample counts based on the first plurality of sample counts; and
    determining the second plurality of sample data having the second plurality of sample counts based on the ratio, the time difference, the first plurality of sample counts, the first plurality of sample data and the second plurality of sample counts.

5.  The method of claim 4, wherein determining a ratio and a time difference between the second clock and the first clock comprises, for each second the first clock elapses:

determining a ratio between a length of time elapsed by the second clock and a length of time elapsed by the first clock as the ratio between the first clock and the second clock for the second; and

determining a difference between a current time of the second clock and a current time of the first clock as the time difference between the first clock and the second clock for the second.

6. The method of claim 4, wherein determining the second plurality of sample counts based on the first plurality of sample counts comprises:

determining a maximum sample count and a minimum sample count among the first plurality of sample counts; for each of the maximum sample count and the minimum sample count, determining a specific maximum sample count and a specific minimum sample count corresponding to the maximum sample count and the minimum sample count, respectively, based on the ratio, the time difference, the first sampling frequency and a second sampling frequency; and determining integers between the specific maximum sample count and the specific minimum sample count as the second plurality of sample counts, wherein the second sampling frequency is a predetermined sampling frequency.

7. The method of claim 4, wherein determining the second plurality of sample data having the second plurality of sample counts based on the ratio, the time difference, the first plurality of sample counts, the first plurality of sample data and the second plurality of sample counts comprises, for each sample count of the second plurality of sample counts:

determining a specific sample count corresponding to the sample count based on the ratio, the time difference, the first sampling frequency and the second sampling frequency; determining a specific sample data having the specific sample count based on the first plurality of sample counts, the first plurality of sample data and the specific sample count; and determining the specific sample data as a sample data having the sample count.

8. The method of claim 7, wherein determining a specific sample data having the specific sample count based on the first plurality of sample counts, the first plurality of sample data and the specific sample count comprises:

determining, among the first plurality of sample counts, a sample count being numerically closest to the specific sample count; and determining a sample data having the sample count as the specific sample data.

9. The method of claim 7, wherein determining a specific sample data having the specific sample count based on the first plurality of sample counts, the first plurality of sample data and the specific sample count comprises:

determining, among the first plurality of sample counts, two sample counts that are numerically adjacent to the specific sample count; and interpolating, based on two sample data having the two sample counts, to determine the specific sample data.

10. The method of claim 1, wherein determining whether a circuit failure occurs based on a value of the differential current comprises:
determining that the circuit failure occurs when the value of the differential current is greater than a threshold.

11. The method of claim 1, further comprising:

storing the second plurality of sample data having the second plurality of sample counts; and transmitting the second plurality of sample data having the second plurality of sample counts to the one or more other differential relaying protection apparatuses.

12. A differential relaying protection apparatus, comprising:

a clock module configured to create a first clock and a second clock, wherein the first clock and the second clock run independently; a transceiver module; and

a processing module configured to perform the method of any one of claims 1-11.

**13.** A differential relaying protection apparatus, comprising:

a first clock module configured to create a first clock;
a second clock module configured to create a second clock, wherein the first clock and the second clock run independently;
a transceiver module; and
a processing module configured to perform the method of any one of claims 1-11.

**14.** A power device, comprising:
a differential relaying protection apparatus configured to perform the method of any one of claims 1-11.

**15.** A computer-readable storage medium having computer-executable instructions stored thereon, when executed by a processor, the instructions being used to implement the method of any one of claims 1-11.

FIG. 1

FIG. 2

FIG. 3

401

Obtaining a first plurality of sample data having a first plurality of sample counts

402

Mapping the first plurality of sample data having the first plurality of sample counts to a second plurality of sample data having a second plurality of sample counts

403

Receiving a plurality of sample data having the second plurality of sample counts from one or more other differential relaying protection apparatuses

404

Determining a differential current based on the second plurality of sample data having the second plurality of sample counts and the received plurality of sample data having the second plurality of sample counts

405

Determining whether a circuit fault occurs based on the value of the differential current

FIG. 4

Clock Module
501A

Transceiver
Module
502A

Processing
Module
503A

Differential Relaying Protection Apparatus
500A

FIG. 5A

First Clock Module
501B

Second Clock
Module
502B

Transceiver Module
503B

Processing Module
504B

Differential Relaying Protection Apparatus
500B

FIG. 5B

Non-transitory Readable
Storage Medium
600

Computer Instructions
610

FIG. 6

Europäisches
Patentamt

European
Patent Office

Office européen
des brevets

## EUROPEAN SEARCH REPORT

**Application Number**

EP 25 21 5830

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 102 546 146 A (GUANGZHOU SWITCH COMP TECHNOLOGY CO LTD; UNIV SOUTH CHINA TECH) 4 July 2012 (2012-07-04) | 1-4,6-15 | INV. H02H1/00 H02H7/26 |
| Y | * translation enclosed; paragraphs [0003] - [0067]; figures 1-4 * | 5 | H04J3/06 H02H3/28 |
| X | JP 7 178973 B2 (MITSUBISHI ELECTRIC CORP) 28 November 2022 (2022-11-28) * translation enclosed; paragraphs [0012], [0036] - [0073]; figures 1-5 * | 1-3, 10-15 | |
| Y | SUN BO ET AL: "Research on Differential Protection Phase Synchronization of Distribution Networks Based on 5G Communication", 2023 8TH ASIA CONFERENCE ON POWER AND ELECTRICAL ENGINEERING (ACPEE), IEEE, 14 April 2023 (2023-04-14), pages 2667-2671, XP034352630, DOI: 10.1109/ACPEE56931.2023.10135601 [retrieved on 2023-05-31] * Sections B and C, eqs 2-6 * | 5 | |

**TECHNICAL FIELDS SEARCHED (IPC)**

H02H
H04J

The present search report has been drawn up for all claims

| Place of search | Date of completion of the search | Examiner |
|---|---|---|
| Munich | 6 March 2026 | Gomes Guerreiro, G |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...........................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 21 5830

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2026

| Patent document cited in search report | | Publication date | Patent family member(s) | | Publication date |
|---|---|---|---|---|---|
| CN 102546146 | A | 04-07-2012 | NONE | | |
| JP 7178973 | B2 | 28-11-2022 | JP | 7178973 B2 | 28-11-2022 |
| | | | JP | 2021027785 A | 22-02-2021 |

EPO FORM P0459

For more details about this annex : see Official Journal of the European Patent Office, No. 12/82